Europäisches Patentamt

European Patent Office

Office européen des brevets

(19)

(11) Veröffentlichungsnummer: **0 136 444**
**B1**

(12) **EUROPÄISCHE PATENTSCHRIFT**

(45) Veröffentlichungstag der Patentschrift:
10.06.87

(51) Int. Cl.⁴: **H 01 L 23/32,** H 01 L 23/48,
H 01 L 29/743

(21) Anmeldenummer: **84108717.4**

(22) Anmeldetag: **24.07.84**

(54) **Leistungsthyristor auf einem Substrat.**

(30) Priorität: **31.08.83 DE 3331298**

(43) Veröffentlichungstag der Anmeldung:
**10.04.85 Patentblatt 85/15**

(45) Bekanntmachung des Hinweises auf die Patenterteilung:
**10.06.87 Patentblatt 87/24**

(84) Benannte Vertragsstaaten:
**CH DE FR GB IT LI NL**

(56) Entgegenhaltungen:
**DE-B-1 107 710**
**US-A-4 127 863**
**US-A-4 148 053**

(73) Patentinhaber: **BROWN, BOVERI & CIE
Aktiengesellschaft, Kallstadter Strasse 1, D-6800
Mannheim 31 (DE)**

(72) Erfinder: **Neidig, Arno, Dr. Dipl.- Phys.,
Brühlerweg 42, D-6831 Plankstadt (DE)**
Erfinder: **Berndes, Günter, Dr. Dipl.- Phys., Im
Kantelacker 30, D-6148 Heppenheim (DE)**
Erfinder: **Meyer, Eckhard, Ing. grad., Lindenhof 24,
CH- 5430 Wettingen (CH)**

(74) Vertreter: **Kempe, Wolfgang, Dr., c/o BROWN,
BOVERI & CIE AG ZPT Postfach 351, D-6800
Mannheim 31 (DE)**

EP 0 136 444 B1

## Beschreibung

Die Erfindung betrifft einen Leistungsthyristor, der auf ein isolierendes, metallisiertes Substrat aufgelötet ist. Anordnungen von einem oder mehreren aktiven Halbleiterbauelementen auf einem Substrat, gegebenenfalls zusammen mit passiven Bauelementen, sind als hybride Schaltungen bekannt, die z. B. in Modulgehäuse eingesetzt werden.

Die Montage von Thyristoren in Form von nicht gekapselten Chip auf einem Substrat erfolgt bei bekannten Anordnungen so, daß die Anodenseite des Thyristors unten ist, d.h. dem Substrat zugewendet ist, während die Seite mit Kathode und Gate vom Substrat abgewendet ist. Die Kontaktierung des Thyristors mit metallisierten Flächen des Substrats erfolgt im wesentlichen entweder durch Druckkontakt oder durch Lötung.

Bei einer Kontaktierung durch Druckkontakt wird der Thyristor vor dem Einbau mit der Anodenseite auf eine Molybdänronde auflegiert, damit die notwendige Stabilität für einen Druckkontakt erreicht wird. Ein Nachteil der Druckkontakttechnik besteht darin, daß sie weniger geeignet ist für Hybridschaltungen, bei denen mehrere Bauelemente verschiedenen Durchmessers in einem Modul angeordnet werden sollen.

Bei hybriden Aufbauten in Lötkontakttechnik erreicht man eine größere Flexibilität und Wirtschaftlichkeit als beim Druckkontakt, wenn mehrere Bauelemente verschiedenen Durchmessers zusammengefaßt werden sollen. Beim Lötkontakt geht man zunehmend von sogenannten glaspassivierten Thyristoren oder anderen glaspassivierten Aktivteilen aus. Diese besitzen außen am Rand auf beiden Seiten eine umlaufende geätzte Rille, in die ein Passivierungsglas eingeschmolzen wird. Leistungsthyristoren mit Sperrspannungen oberhalb etwa 800 V werden mit der Anodenseite auf ein kleines Podest (mit einer etwas kleineren Fläche im Vergleich zur Anodenfläche) aufgelötet, um bei Anlegen von Sperrspannung ein Überschlagen vom Passivierungsrand auf eine auf Anodenpotential liegende Substratmetallisierung bzw. auf eine Kontaktelektrode zu vermeiden. Zur Verbindung der Kathoden- und Gate-Anschlüsse von Thyristoren mit metallisierten Flächen auf einem Substrat oder mit anderen Anschlüssen, werden Kontaktbügel verwendet. Da die Abstände zwischen der Gate- und der Kathodenelektrode eines Thyristorchip klein sind (unter 1 mm), ist eine große Sorgfalt bei der Plazierung der Kontaktbügel erforderlich; mitunter sind dafür besondere Hilfsvorrichtungen erforderlich. Weiterhin ist nachteilig, daß bei ungenauer Blazierung oder durchverbogene Kontaktbügel fehlerhafte Anschlüsse oder Verbindungen entstehen können, die zu einer erhöhten Ausschußrate führen. Schließlich ist der Bestückungsaufwand dadurch hoch, daß relativ viele Einzelteile, nämlich zumindest eine Abstandsronde, zwei Kontaktbügel und zwei Lotplättchen verwendet werden müssen.

Der Erfindung liegt die Aufgabe zugrunde, den Aufbau und die Herstellung hybrider Schaltungen mit Leistungshalbleiterbauelementen unter Verwendung der Lötkontakttechnik zu vereinfachen. Dazu soll eine Ausführung des Thyristorchip angegeben werden, die eine geringere Anzahl von zu verbindenden Teilen erforderlich macht und schließlich zu einer verringerten Ausschußrate bei der Herstellung hybrider Schaltungen führt.

Diese Aufgabe wird durch einen Leistungsthyristor, der auf ein isolierendes und metallisiertes Substrat aufgelötet ist, mit den kennzeichnenden Merkmalen des Anspruche 1 gelöst.

Die damit vorgeschlagene Lösung hat den Vorteil, daß die sonst notwendigen kleinen Kontaktbügel für den Gate-Anschluß entfallen, da der Gate-Anschluß einfach durch eine entsprechende Substratmetallisierung hergestellt wird. Es muß nur noch von der jetzt oben liegenden Anodenseite eine Verbindung mittels Kontaktbügel hergestellt werden, wobei dieser Kontaktbügel einfach und unkritisch zu plazieren ist. Besonders vorteilhaft ist die vorgeschlagene Lösung bei Verwendung einer mit Kupfer metallisierten Aluminiumoxid-Keramik als Substrat, da zwischen Silizium und Aluminiumoxid-Keramik nur geringe Ausdehnungsunterschiede bestehen.

Gemäß der vorgeschlagenen Ausführung des Thyristors ist auf der Oberseite des Thyristors die Anodenfläche von einem Passivierungsgraben für den anodenseitigen Sperrübergang und den kathodenseitig blockierenden pn-Übergang umgeben. Nach einer vorteilhaften Ausgestaltung kann das Hochziehen des kathodenseitig blockierenden pn-Übergangs auf die Anodenseite durch Trenndiffusion erreicht werden. Alternativ hierzu kann dies auch durch Thermomigration erreicht werden.

Nach einer weiteren vorteilhaften Ausgestaltung wird vorgeschlagen, das Gate in einem Teil des Randbereiches der Thyristorunterseite anzuordnen. Damit erübrigt sich für den Gate-Anschluß eine Leitungsführung unter dem Kathodenanschluß hindurch, die bei einer Anordnung des Gate in einem mittleren Bereich der kathodenseitigen Fläche erforderlich wäre.

Die Erfindung wird nachstehend anhand der Zeichnung und Ausführungsbeispielen näher erläutert.

Es zeigen:

Fig. 1 bis 5 einen erfindungsgemäßen Leistungsthyristor jeweils am Ende mehrerer aufeinanderfolgender Herstellungsschritte,

Fig. 6 und 7 Kathoden- und Gateseite des Leistungsthyristors gemäß einem ersten Ausführungsbeispiel mit zwei alternativen Ausführungen des Gate-Anschlusses

Fig. 8 Anodenseite des Leistungsthyristors,

Fig. 9 auf ein Substrat aufgeloteter Leistungsthyristor,

Fig. 10 Kathoden- und Gateseite eines Leistungsthyristors gemäß einem zweiten Ausführungsbeispiel,

Fig. 11 Anodenseite des Leistungsthyristors nach dem zweiten Ausführungsbeispiel.

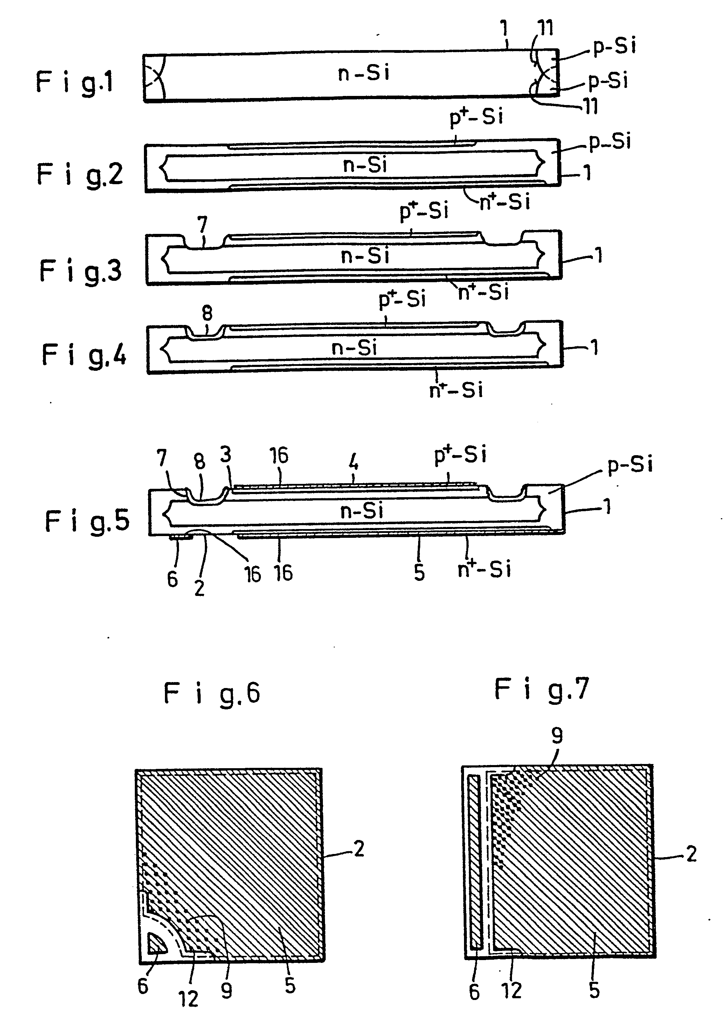

Die Fig. 1 bis 5 zeigen einen erfindungsgemäßen Leistungsthyristor bzw. Thyristorchip 1 jeweils am Ende einzelner Herstellungsschritte. Der dabei dargestellte Thyristorchip 1 ist ein Teil einer noch unzerteilten Siliziumscheibe von etwa 3 Zoll Durchmesser.

Fig. 1 zeigt einen Thyristorchip 1 am Ende eines sogenannten Trenndiffusionsprozesses mit n-Silizium als Basismaterial. Dabei wird an der Peripherie des Chip 1 von beiden Seiten Aluminium tief eindiffundiert, bis sich die dabei bildenden Diffusionsfronten 11 überlappen. Aluminium wird bevorzugt verwendet, weil es schnell diffundiert und weil es sich selektiv eindiffundieren läßt. Den Trenndiffusionsprozeß führt man im allgemeinen als ersten Prozeß durch, weil er am längsten dauert.

Fig. 2 zeigt den Thyristorchip 1 nach Durchführung weiterer maskierter Standard-Diffusionsprozesse, die hier nicht weiter beschrieben werden und die zu einer dargestellten pnpn-Vierschichtstruktur führen. Dabei können in bekannter Weise Emitterkurzschlüsse im Kathodenbereich vorgesehen sein.

Anschließend werden auf der p+-Seite also der oben liegenden Anodenseite die pn-Übergänge freigelegt, um die anodenseitigen Sperr- und kathodenseitigen Blockiereigenschaften des Bauelementes herzustellen. Dies geschieht zweckmäßig durch Ätzen, wobei Passivierungsgräben 7 entstehen, wie in Fig 3 dargestellt.

Fig. 4 zeigt den Thyristorchip 1, nachdem zur Passivierung eine Passivierungschicht 8 auf die Gräben 7 aufgebracht ist. Die Passivierung erfolgt mit einem Glas oder durch Abscheidung von Schichten aus der Gasphase.

Anschließend werden die Bereiche der Anode 4, der Kathode 5 und des Gate 6 metallisiert, z.B. durch physikalisches Aufdampfen von Metallschichten 16 wie in Fig. 5 dargestellt. Nach dem Zerteilen der Scheibe - vorzugsweise durch Sägen, alternativ durch Trennen mit einem Laserstrahl - erhält man einzelne Thyristorchip 1.

In Fig. 6 und 7 sind alternative Ausführungsbeispiele für die Gestaltung der Kathoden- und Gateseite 2 des Thyristorchip 1 dargestellt, wobei der Anschluß des Gate 6 entweder an einer Ecke oder an einer Kante der Chipfläche vorgesehen ist zur Vereinfachung der Leitungsführung auf einem Substrat, auf das der Thyristorchip 1 aufgelötet werden soll. Die Fig. 6 und 7 zeigen außerdem ein n+-Gebiet 12 mit der großflächigen Kathode 5 und mit angedeuteten Emitterkurzschlüssen 9. Die Kathodenmetallisierung ist an den Ecken in Gate-Nähe etwas zurückversetzt, um einen niederohmigen Nebenschluß zwisschen Gate-und Kathode zu vermeiden. Aus dem gleichen Grund liegt die Gate-Metallisierung mit Abstand zur Chip-Kante, um eine Kontaktierung des hochdotierten, trenndiffundierten Randbereichs zu vermeiden (vgl. Fig. 5, 6, 7, 9 und 10).

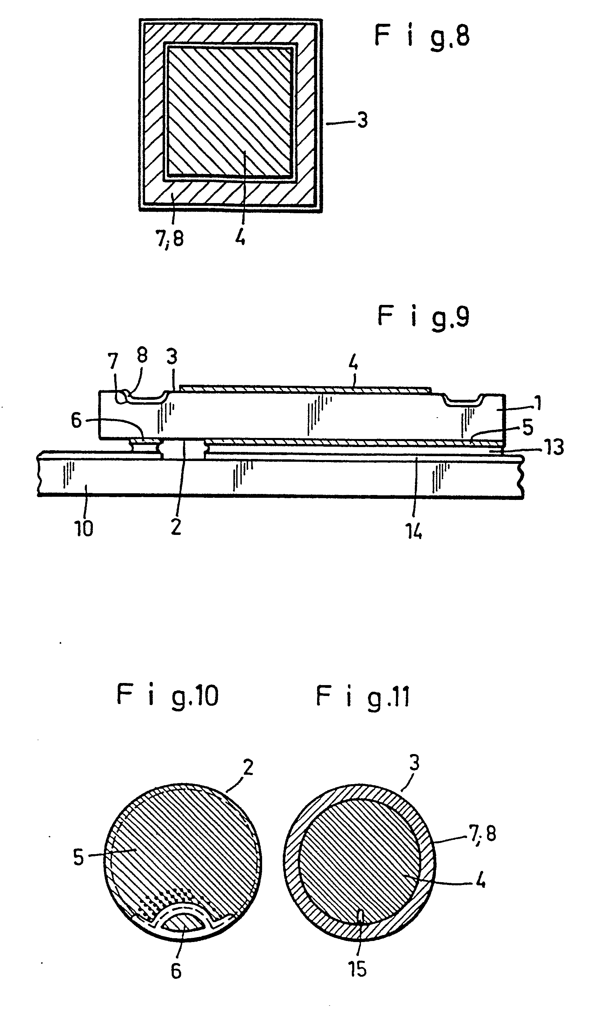

Fig. 8 zeigt ein Ausführungsbeispiel der Anodenseite 3, wobei die Anode 4 zu erkennen ist, die von einem Passivierungsgraben 7 mit einer Passivierungsschicht 8 umgeben ist.

Fig. 9 zeigt schließlich den auf ein Substrat 10 mit Hilfe einer Lotschicht 13 aufgelöteten Thyristorchip 1. Im einzelnen sind zu erkennen: die Anodenseite 3 mit der Anode 4 und den mit einer Passivierungsschicht 8 beschichteten Passivierungsgraben 7 sowie die dem Substrat 10 zugewandten Kathoden- und Gateseite 2 mit der Kathode 5 und dem Gate 6. Das Substrat 10 besteht aus einer Aluminiumoxid-Keramik, die direkt mit einer entsprechend der erforderlichen Schaltung strukturierten Metallfolie (Kupferfolie) 14 verbunden ist. Temperaturänderungen zerstoren den Chip nicht da die thermischen Ausdehnungsunterschiede zwischen Keramik und Silizium sehr gering sind.

Ein zweites Ausführungsbeispiel für den Thyristorchip 1, nämlich eine runde Ausführung anstelle der quadratischen Ausführung gemäß dem ersten Beispiel, ist in den Fig. 10 und 11 dargestellt.

Fig. 10 zeigt dabei die Kathoden- und Gateseite 2 mit der Kathode 5 und dem Gate 6. Die Anodenseite 3 mit der Anode 4 und dem mit einer Passivierungsschicht 8 versehenen Passivierungsgraben 7 ist aus Fig. 11 zu ersehen. Als optische Bestückungshilfe kann auf der Anodenseite in der Metallisierung eine Markierung 15 vorgesehen werden, die die Lage des auf der Unterseite befindlichen Anschlusses für das Gate 6 anzeigt.

## Patentansprüche

1. Leistungsthyristor, der auf ein isolierendes und metallisiertes Substrat aufgelötet ist, dadurch gekennzeichnet, daß
- der Leistungsthyristor (1) mit seiner Kathoden- und Gateseite (2) nech unten auf das Substrat (10) aufgelötet ist und
- die an der Oberseite des Thyristors (1) befindliche Fläche der Anode (4) von einem Passivierungsgraben (7) umgeben ist, der gemeinsam ist für den anodenseitigen Sperrübergang und für den kathodenseitig blockierenden pn-Übergang.

2. Leistungsthyristor nach Anspruch 1, dadurch gekennzeichnet daß ein Gate (6) in einem Teil des Randbereiches der Kathoden- und Gateseite (2) angeordnet ist.

3. Verfahren zur Herstellung eines Leistungsthyristors nach Anspruch 1 oder 2, dadurch gekennzeichnet, daß der kathodenseitig blockierende pn-Übergang durch Trenndiffusion auf die Anodenseite (3) gebracht wird.

4. Verfahren zur Herstellung eines Leistungsthyristors nach Anspruch 1 oder 2, dadurch gekennzeichnet, daß der kathodenseitig blockierende pn-Übergang durch Thermomigration auf die Anodenseite (3) gebracht wird.

**Claims**

1. Power thyristor which is soldered on to an insulating and metallized substrate, characterized in that
- the power thyristor (1) is soldered on to the substrate (10) with its cathode and gate side (2) facing downwards and
- the area of the anode (4), which is located at the top of the thyristor (1), is surrounded by a passivation trench (7) which is common to the anode-side blocking junction and to the cathode-side blocking pn junction.

2. Power thyristor according to Claim 1, characterized in that a gate (6) is arranged in a part of the edge region of the cathode and gate side (2).

3. Method for producing a power thyristor according to Claim 1 or 2, characterized in that the cathode side blocking pn junction is brought to the anode side (3) by separation diffusion.

4. Method for producing a power thyristor according to Claim 1 or 2, characterized in that the cathode-side blocking pn junction is brought to the anode side (3) by thermomigration.

**Revendications**

1. Thyristor de puissance soudé sur un substrat isolant et métallisé, <u>caractérisé</u> en ce que
- le thyristor de puissance (1) est soudé sur le substrat (10) par son côté cathode et gâchette (2) tourné vers le bas, et
- la surface de l'anode (4) située sur le côté supérieur du thyristor (1) est entourée par une rigole de passivation (7) qui est commune pour la jonction d'arrêt du côté anode et pour la jonction pn bloquante du côté cathode.

2. Thyristor de puissance selon revendication 1, caractérisé en ce qu'une gâchette (6) est agencée dans une partie de la région du bord du côté cathode et gâchette (2).

3. Procédé de réalisation d'un thyristor de puissance selon revendication 1 ou 2, caractérisé en ce que la jonction pn bloquante du côté cathode est réalisée par diffusion d'isolement du côté anode (3).

4. Procédé de réalisation d'un thyristor de puissance selon revendication 1 ou 2, caractérise en ce que la jonction pn bloquante du côté cathode est réalisée par thermomigration du côté anode (3).

F i g.1

F i g.2

F i g.3

F i g.4

F i g.5

F i g.6

F i g.7

F i g.8

3

7,8    4

F i g.9

7  8  3    4

6    1

5
13

10    2    14

F i g.10    F i g.11

2    3

5    7,8

6    4

15